Europäisches Patentamt

European Patent Office

Office européen des brevets

(19)

(11) Veröffentlichungsnummer : **0 328 778 B1**

## (12) EUROPÄISCHE PATENTSCHRIFT

(45) Veröffentlichungstag der Patentschrift :
**11.03.92 Patentblatt 92/11**

(51) Int. Cl.$^5$ : **H03K 17/73, H01L 29/60**

(21) Anmeldenummer : **88121453.0**

(22) Anmeldetag : **22.12.88**

(54) **Hochleistungsschalter.**

(30) Priorität : **26.01.88 CH 262/88**

(43) Veröffentlichungstag der Anmeldung :
**23.08.89 Patentblatt 89/34**

(45) Bekanntmachung des Hinweises auf die
Patenterteilung :
**11.03.92 Patentblatt 92/11**

(84) Benannte Vertragsstaaten :
**AT CH DE FR GB IT LI NL SE**

(56) Entgegenhaltungen :
**EP-A- 0 228 226**
**DE-A- 3 134 074**

(56) Entgegenhaltungen :
**PATENT ABSTRACTS OF JAPAN, Band 9, Nr.
288 (E-358)[2011], 15. November 1985, Seite 67
E 358 & JP-A-60 128 713 (MITSUBISHI DENKI
K.K.) 09-07-1985**
**SIEMENS COMPONENTS, Band 19, Nr. 6, Dezember 1984, Seiten 264-268, Berlin, DE; W.
GOLDBRUNNER et al.: "Capacitors for GTO
thyristors"**

(73) Patentinhaber : **ASEA BROWN BOVERI AG**
**Haselstrasse**
**CH-5401 Baden (CH)**

(72) Erfinder : **Grüning, Horst, Dr.**
**Im Ergel 10**
**CH-5404 Baden (CH)**

EP 0 328 778 B1

## Beschreibung

Die vorliegende Erfindung bezieht sich auf das Gebiet der Leistungselektronik. Sie betrifft insbesondere einen Hochleistungsschalter, umfassend

(a) ein über ein Gate abschaltbares Halbleiterbauelement; und

(b) eine Ansteuereinheit, welche den zum Abschalten notwendigen Gatestrom erzeugt; wobei

(c) die Ansteuereinheit in eine Mehrzahl von parallel arbeitenden Untereinheiten aufgeteilt ist, welche jeweils einen Teil des zum Abschalten notwendigen Gatestroms erzeugen.

Ein solcher Hochleistungsschalter ist z.B. aus der Druckschrift PATENT ABSTRACTS OF JAPAN, Band 9, Nr. 288 (E-358) [2011], 15. November 1985, S. 67 E 358, bekannt.

## STAND DER TECHNIK

In der Leistungselektronik gewinnen neben herkömmlichen Thyristoren, die nur nach dem Unterschreiten eines bestimmten Haltestroms in den sperrenden Zustand gebracht werden können, zunehmend Bauelemente an Bedeutung, die direkt über ein Gate abgeschaltet werden können.

Bekannte Formen dieser abschaltbaren Bauelemente sind z.B. der GTO (Gate-Turn-Off Thyristor), der FCTh (Field Controlled Thyristor) und der SITh (Static Induction Thyristor).

Während der Abschaltphase werden bei diesen GTOs, FCThs, SIThs und ähnlichen bipolaren Hochleistungsbauelementen innerhalb kurzer Zeit grosse Gateströme benötigt (siehe dazu: EP-A2 0 077 930)

Diese Gateströme müssen einer Quelle mit relativ kleiner Spannung entnommen werden, damit die Gate-Kathoden-Strecke des Bauelements nicht durch einen Avalanche-Durchbruch zerstört wird. Daraus ergibt sich für den Ansteuerkreis die Forderung nach einer möglichst kleinen Induktivität bei gleichzeitig extrem hoher Pulsbelastbarkeit.

Bisherige Ansteuerkonzepte entsprechen dieser Forderung nur in geringem Masse: Durch geeignete Ausgestaltung der Gatekontaktierung in Form von Zentral- oder Ringgates bemühen sich diese Konzepte (siehe z.B. DE-A- 31 34 074) zwar um eine gleichmässige Verteilung des Gatestroms auf dem Halbleitersubstrat, d.h. der steuerseitigen Bauelementoberfläche.

Art und Aufbau der für das Abschalten notwendigen Ansteuereinheit werden jedoch bei diesen Bemühungen ausser Betracht gelassen. So wird beispielsweise die Ansteuereinheit mit ihrer Stromquelle und dem dazugehörigen Schalter als kompakte Einheit weit entfernt vom eigentlichen Bauelement angeordnet.

Die bei dieser Anordnung notwendigen langen Zuleitungen tragen überwiegend zur unerwünschten Kreisinduktivität bei und begrenzen den Wert der erreichbaren Stromanstiegsgeschwindigkeit dI/dt (siehe z.B.: Siemens Components $\underline{25}$ (1987), S. 24-26).

So ergibt sich z.B: bei GTOs trotz einer künstlich gesteigerten Abschalt-Stromverstärkung von $I_{TGQM}/I_{GQ}$ von grösser 4 eine Abschaltverzugszeit $t_s$, die weit grösser als die Fallzeit $t_f$ ist. Dies führt zur Bildung von Stromfilamenten, weil der GTO zu langsam angesteuert wird, und deshalb Teilbereiche schon abgeschaltet sein können, während andere noch vollkommen mit Ladungsträgern überschwemmt sind.

Aufgrund der elektrischen Aehnlichkeit gibt es vergleichsweise Mechanismen der Filamentbildung auch bei den FCThs. Bereits existierende FCThs relativ kleiner Leistung (10 A) werden daher mit grossem Gatestrom (Abschaltverstärkung kleiner 1) und sehr hohem $dI_G/dt$ ($I_G$ = Gatestrom) betrieben. So wird die Injektion von Elektronen in alle Bereiche durch die Kathode unterbrochen, bevor sich die Raumladungszone zwischen Gate und Anode aufbauen kann, und eine Filamentbildung sicher vermieden.

Die Anwendung in grossen Umrichtern verlangt jedoch FCThs weitaus grösserer Leistung (500 A - 3000 A). Entsprechend steigen die Anforderungen an die Ansteuerung, und die Kreisinduktivität der derzeitigen Ansteuerkreise muss etwa um den Faktor 50 bis 300 reduziert werden.

Eine solche Reduktion ist aber durch eine einfache Kaskade, wie sie in der EP-A 0 246 478 vorgeschlagen worden ist, nicht zu erreichen, weil bereits die Eigeninduktivität der besten derzeit verfügbaren Kondensatoren (5 nH) deutlich über dem geforderten Wert von weniger als 1 nH liegt.

In der eingangs genannten Druckschrift (PATENT ABSTRACTS OF JAPAN...) ist nun vorgeschlagen worden, zur Verbesserung des dI/dt-Wertes für den Gatestrom in der Ansteuerschaltung zwei parallelgeschaltete Impulstransformatoren zu verwenden. Nicht berücksichtigt wird hierbei jedoch die kritische Verbindung zwischen dem Ausgang der Ansteuerschaltung und dem Gate des Bauelements.

## DARSTELLUNG DER ERFINDUNG

Aufgabe der vorliegenden Erfindung ist es nun, einen Hochleistungsschalter zu schaffen, bei dem durch geeignete Massnahmen auf der Ansteuerseite die den Stromanstieg begrenzende Induktivität des Ansteuerkreises drastisch reduziert wird.

Die Aufgabe wird bei einem Hochleistungsschalter der eingangs genannten Art dadurch gelöst, dass

(d) das abschaltbare Halbleiterbauelement eine räumlich verteilt angeordnete Gateelektrode aufweist; und

(e) die Untereinheiten an verschiedenen Stellen der räumlich verteilten Gateelektrode angeschlossen sind.

Der Kern der Erfinfdung besteht darin, durch Parallelschaltung mehrerer Untereinheiten und Anschluss der Untereinheiten an verschiedenen Stellen einer räumlich verteil angeordneten Gateelektrode die Wirkung der Eigeninduktivitäten der Ansteuerbauelemente in den Untereinheiten zu verringern.

Hierdurch werden auch die Leitungen zwischen Ansteuereinheit und Gateelektrode in die Parallelschaltung einbezogen und die Induktivität weiter reduziert.

Besonders vorteilhaft ist es dabei, die Untereinheiten möglichst nahe am Bauelement selbst zu plazieren, insbesondere in das Gehäuse zu integrieren.

Weitere Ausführungsbeispiele der Erfindung ergeben sich aus den abhängigen Anspruchen.

## KURZE BESCHREIBUNG DER ZEICHNUNG

Die Erfindung soll nachfolgend im Zusammenhang mit der Zeichnung anhand von Ausführungsbeispielen näher erläutert werden. Es zeigen:

Fig. 1 das Prinzipschaltbild eines Hochleistungsschalters mit Abschaltthyristor nach dem Stand der Technik;

Fig. 2 ein Beispiel für einen GTO nach dem Stand der Technik;

Fig. 3A,B zwei Ausführungsformen einer Ansteuereinheit nach dem Stand der Technik;

Fig. 4 eine Ansteuereinheit gemäss einem ersten Ausführungsbeispiel der Erfindung;

Fig. 5 Draufsicht auf und Schnitt durch einen Hochleistungsschalter gemäss einem zweiten Ausführungsbeispiel der Erfindung; und

Fig. 6 im Schnitt die kathodenseitige Ausgestaltung eines Hochleistungsschalters gemäss einem weiteren Ausführungsbeispiel der Erfindung.

## WEGE ZUR AUSFÜHRUNG DER ERFINDUNG

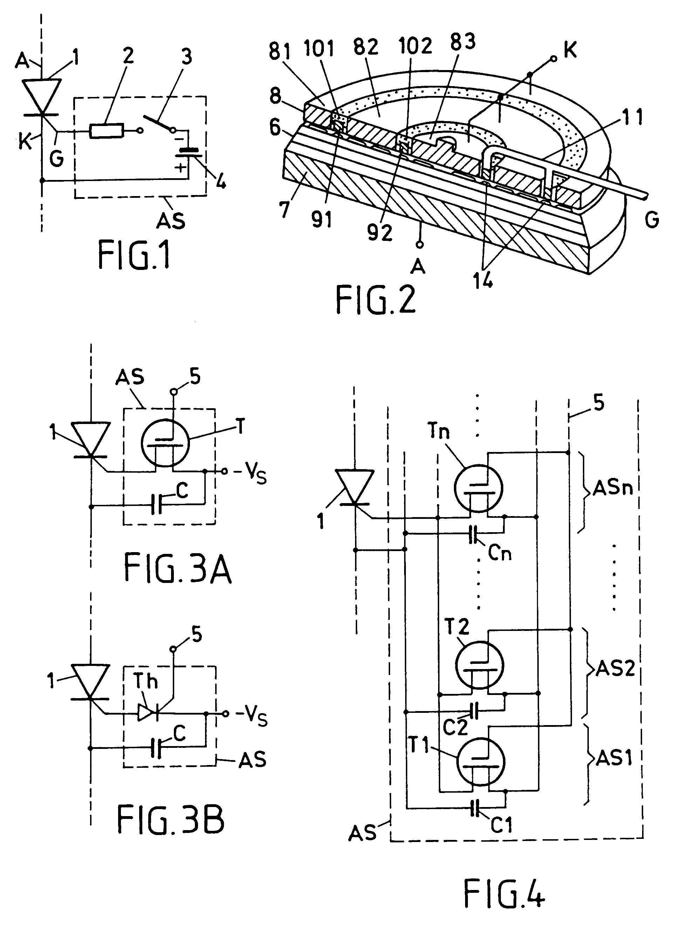

Die Prinzipschaltung eines Hochleistungsschalters mit einem Abschaltthyristor 1 ist in Fig. 1 dargestellt. Der Abschaltthyristor 1 liegt mit seiner Anode A und seiner Kathode K in einem nicht eingezeichneten Hauptstromkreis.

An das Gate G und die Kathode K des Thyristors ist eine Ansteuereinheit AS angeschlossen, die üblicherweise sowohl Mittel zum Ein- als auch zum Abschalten des Thyristors enthält. Da sich die Erfindung nur mit den beim Ausschalten auftretenden Problemen beschäftigt, ist in dieser und allen weiteren Figuren nur auf den Abschaltstromkreis Bezug genommen.

Dieser Abschaltstromkreis umfasst prinzipiell einen steuerbaren Schalter 3 und eine Stromquelle 4, die in Reihe geschaltet sind. Zusätzlich ist noch eine Induktivität 2 zu berücksichtigen, welche die Eigeninduktivität der Elemente der Ansteuereinheit sowie die Induktivität der Zuleitungen zum Gate G einschliesst.

In einer realen Ansteuereinheit AS kann der Schalter 3 z.B. durch einen Ansteuertransistor T vom MOSFET-Typ (Fig. 3A) oder durch einen Ansteuerthyristor Th vom FCTh-Typ (Fig. 3B) realisiert werden. Andere Typen von Halbleiterschaltern wie GTOs oder schnelle herkömmliche Thyristoren sind gleichfalls denkbar.

Als Stromquelle 4 wird bevorzugt ein von einer Steuerspannung $V_S$ aufgeladener Kondensator C verwendet (Fig. 3A, B), da zum Abschalten nur ein kurzzeitiger Gatestrom-Impuls benötigt wird.

Es versteht sich von selbst, dass in den Fig. 1, 3A und 3B nur die prinzipiellen Elemente der Ansteuereinheit wiedergegeben sind, und dass eine vollständige Ansteuerschaltung wesentlich komplexer aufgebaut ist (siehe z.B. die EP-A 0 246 478).

Wie bereits erwähnt, umfasst die Induktivität 2, die den erreichbaren Stromanstieg $dI_G/dt$ im Gatestromkreis bestimmt, sowohl die Zuleitungsinduktivitäten als auch die Eigeninduktivität der ausserhalb des Abschaltthyristors 1 angeordneten Ansteuereinheit AS des Hochleistungsschalters.

Die Herkunft der Zuleitungsinduktivitäten kann am Beispiel eines bekannten GTO erläutert werden, der in Fig. 2 dargestellt ist.

Dieser GTO, der im Beispiel (aber nicht notwendigerweise) rotationssymmetrisch ausgeführt ist, enthält ein Halbleitersubstrat 6 mit einer Folge unterschiedlich dotierter Schichten, welches kathodenseitig eine stufen- oder mesaförmige Gate-Kathodenstruktur aufweist.

Zur Kontaktierung ist das Halbleitersubstrat 6 zwischen einer metallischen Anodenplatte 7 und einer metallischen Kathodenplatt 8 angeordnet.

Der Gatezugriff erfolgt in diesem Fall über ringförmige Gateelektroden 14, die zwischen den einzelnen Ringen von Kathoden- bzw. Emitterfingern verlaufen, um eine gleichmässige Verteilung des Gatestroms auf der gesamten Substratfläche zu gewährleisten.

Die Gateelektroden 14 werden durch entsprechende Gateringe 91, 92 kontaktiert, welche in die Kathodenplatte 8, durch eine geeignete Gateringisolierung 101, 102 elektrisch getrennt, eingelassen sind. Die Kathodenplatte 8 setzt sich damit aus mehreren Einzelplatten 81, 82, 83 zusammen.

Von den Gateringen 91, 92 führt eine einzige Gatezuleitung 11 durch das nicht eingezeichnete Gehäuse nach aussen und wird mit der (ebenfalls nicht dargestellten) Ansteuereinheit verbunden.

Es ist leicht erkennbar, dass diese Art des Gateanschlusses unnötigerweise die störende Induktivität des Gatekreises erhöht, welbst wenn, wie in der eingangs zitierten Druckschrift Siemens Components 25 (1987), S. 24 - 26 vorgeschlagen, die Ansteuereinheit möglichst nahe am Gehäuse des Abschaltthyristors plaziert wird.

Eine weitere, wesentliche Quelle für die Induktivität im Gatekreis ist jedoch die Ansteuereinheit selbst: Wie bereits eingangs geschildert, lassen sich mit einem Halbleiterschalter und einem Kondensator C in der Einheit gewisse Induktivitätswerte nicht unterschreiten.

Die Erfindung geht nun den Weg, die Ansteuereinheit AS in eine Vielzahl von gleichartigen, parallel arbeitenden Untereinheiten AS1, ..., ASn aufzuteilen (Fig. 4), wobei jede Untereinheit AS1, ..., ASn mit einem entsprechend kleineren Halbleiterschalter und einem kleineren Kondensator C1, ..., Cn ausgestattet ist und nur einen Teil des erforderlichen Gatestroms bereitstellt.

Im Ausführungsbeispiel der Fig. 4 sind dabei, in Analogie zu Fig. 3A als Halbleiterschalter MOSFET-Ansteuertransistoren T1, ..., Tn eingesetzt. In gleicher Weise können jedoch auch, in Analogie zu Fig. 3B, Ansteuerthyristoren verwendet werden.

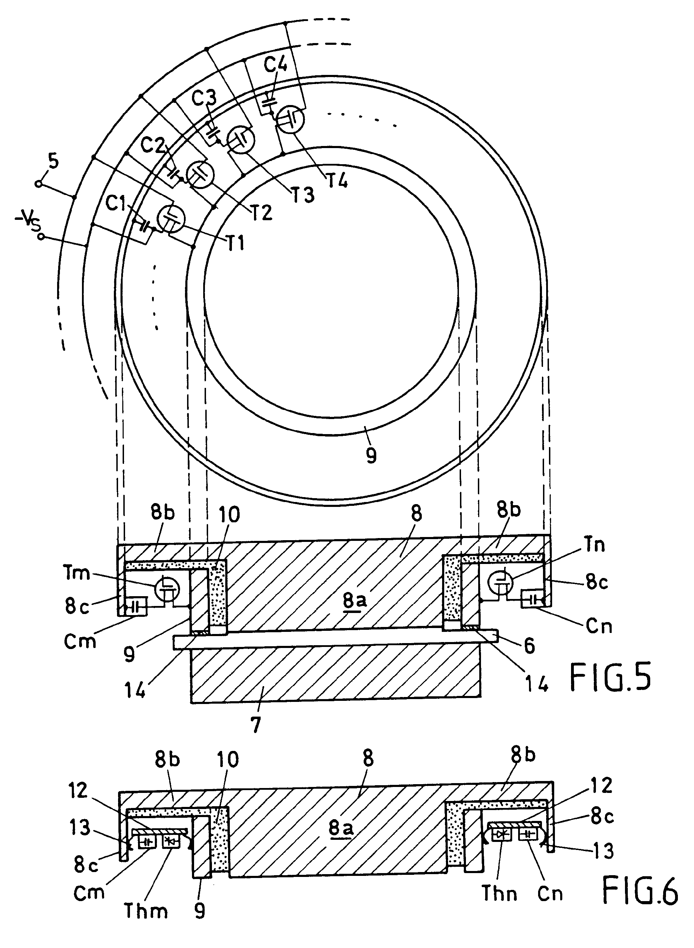

Mit dieser, durch die Aufteilung in Untereinheiten bedingten Parallelschaltung lässt sich auf der Ansteuerseite bereits eine wesentliche Reduktion der Induktivität erzielen. Noch günstiger werden die Verhältnisse jedoch, wenn die Untereinheiten AS1, ..., ASn nicht an eine gemeinsame Gatezuleitung gemäss Fig. 2 angeschlossen werden, sondern, räumlich verteilt, direkt innerhalb des Gehäuses des abschaltbaren Halbleiterbauelements angeordnet und an verschiedenen Stellen der Gateelektrode bzw. des Gaterings angeschlossen werden (Fig. 5).

Mit dieser kombinierten Parallelschaltung mehrerer Untereinheiten und optimalen Anordnung um das abzuschaltende Bauelement herum werden die Zuleitungsinduktivitäten minimiert und die Wirkung der Eigeninduktivitäten der Ansteuerbauelemente verringert.

Gleichzeitig erreicht man eine weit homogenere Ansteuerung des Leistungsschalters, weil der Strom einem Ringgate z.B. von allen Seiten gleichzeitig und mit ähnlicher Impedanz zugeführt wird. Ein optimal gleichzeitiges Abschalten aller Bereiche und damit verbunden beste Voraussetzungen zum homogenen Abschalten des gesamten Hochleistungsschalters sind so also gegeben.

Es ist dabei prinzipiell ganz gleich, ob das abschaltbare Halbleiterbauelement ein GTO, ein FCTh, ein SITh oder sonst ein bipolares Hochleistungsbauelement mit hohem Gatestrombedarf und dI/dt ist. Selbst grossflächige Hochfrequenz-FETs kann man in dieser Form optimal ansteuern.

Auch ist es prinzipiell unbedeutend, ob als Halbleiterschalter MOSFETs, Thyristoren, GTOs oder FCThs verwendet werden. Doch für die Ansteuerung von GTOs und speziell von FCThs ergeben sich natürlich bevorzugte Ausführungsformen:

In einer solchen Ausführungsform werden zur Ansteuerung gemäss der EP-A 0 246 478 FCThs verwendet. Die Gates dieser Ansteuerbauelemente werden untereinander verbunden (entsprechend Fig. 4).

So wird beim Einschalten eines zufällig voreilenden Ansteuer-FCTh dessen Gate durch die von der Anode übernommenen Löcher viel rascher positiv geladen, als der Anodenstrom ansteigen kann, und dieses Potential gelangt über die Verbindung unverzögert an die Gates der anderen FCThs. Als Folge davon werden dann alle FCThs eingeschaltet, und die Verzögerung zwischen den einzelnen FCThs ist wegen des geringen erforderlichen Signalstromes trotz normal grosser Verbindungsinduktivität äusserst gering (wenige ns).

Zum Wiedereinschalten des Hochleistungsschalters bedarf es dann aber nur eines sehr kleinen Stromes am Gate der Ansteuer-FCThs, wie bereits in der EP-A 0 246 478 dargelegt worden ist. Deshalb kann man in den Untereinheiten AS1, ..., ASn nicht nur FCThs und GTOs, sondern auch handelsübliche ns-Thyristoren (z.B. vom Typ GA 300 der Firma Unitrode) verwenden.

Versuche haben gezeigt, dass auch diese Bauelemente die gewünschte gegenseitige Triggerung ausführen und durch negative Gatespannung gegen einen genügend grossen Anodenstrom abgeschaltet werden können, so dass der Hochleistungsschalter in der Folge wieder einschalten kann. Ein besonders kostengünstiger Aufbau wird so erreicht, weil solche Elemente leicht auf EPI-Silizium hergestellt werden können.

Als Kondensatoren C1, ..., Cn in den Untereinheiten AS1, ..., ASn werden bevorzugt handelsübliche Multilayer-Keramikkondensatoren in Chip-Form eingesetzt. Spezielle Versuche haben gezeigt, dass solche Kondensatoren der Firma Siemens (Typ B37985-N5105-M) über 100 A Entladestrom bei einer Wiederholfrequenz von 2 kHz aushalten und damit mehr als das 5fache des in der Anwendung geforderten Wertes.

Ihre Eigeninduktivität ist dabei extrem gering und durch Parallelschalten von entsprechenden Chips (Typ B37957-K5105-M62) lassen sich in der vorgeschlagenen Anordnung die gewünschten kleinen Kreisinduktivitäten leicht erreichen.

Selbstverständlich können diese Chip-Kondensatoren durch Elektrolytkondensatoren unterstützt werden, wenn sich durch sie nicht einfach eine ausreichend grosse Gesamtkapazität erreichen lässt, um auch Höchstspannungs-FCThs oder -GTOs sicher abschalten zu können.

Alle diese Bauelemente sollten natürlich innerhalb des Hauptgehäuses des Hochleistungsschalters untergebracht werden, da sonst notwendige Durchführungen und Zuleitungen den Induktivitätsvorteil teilweise zunichtemachen. Einzig die erwähnten unterstützenden Elektrolytkondensatoren können ausserhalb des Gehäuses angeordnet werden, da ihre Beschaltungsinduktivität wegen der parallel geschalteten Keramik-Kondensatoren nur stark verringert wirksam wird.

So lassen sich auch die geforderten Temperaturgrenzen für den Betrieb des Hochleistungsschalters garantieren, denn bestimmte Keramik-Chips sind sogar bis 125 °C betreibbar. Da sie aber (z.B. bei der Ausführungsform gemäss Fig. 5) direkt mit den Kühlflächen des Gesamtgehäuses in Verbindung stehen, wird ihre Betriebstemperatur solch hohe Werte wegen ihrer geringen Verlustleistung sowieso nicht erreichen.

In der Ausführungsform nach Fig. 5 wird der kathodenseitige Kontakt zu dem Halbleitersubstrat 6 durch einen Gatering 9 und eine Kathodenplatte 8 hergestellt.

Die Kathodenplatte 8 umfasst einen zylindrischen Zentralteil 8a, der direkt auf das Halbleitersubstrat 6 drückt, eine an den Zentralteil 8a anschliessende und radial nach aussen verlaufende Erweiterung 8b, und einen an die Erweiterung 8b anschliessenden Aussenring 8c.

Der zylindrische Zentralteil 8a ist von dem durch eine Gateisolierung 10 isoliert aufgebauten Gatering 9 konzentrisch umgeben und bildet mit dem grösseren Aussenring 8c eine ring-förmige Nut, in der die Kondensatoren Cm, n und Halbleiterschalter (Ansteuertransistoren Tm, n oder Ansteuerthyristoren Thm, n) der Untereinheiten untergebracht sind.

Durch den direkten Anschluss dieser Elemente an den Aussenring 8c bzw. Gatering 9 ergeben sich sehr induktivitätsarme Verbindungen. Durch die ringförmige Verteilung der Untereinheiten wird die Ansteuerung des Hochleistungsbauelements wirksam homogenisiert.

Alle Untereinheiten sind jeweils an gemeinsame Leitungen angeschlossen, die zu einem Steuereingang 5 bzw. zu einer Quelle für die Steuerspannung $V_S$ führen.

Zur weiteren Vereinfachung des Aufbaus wird darüber hinaus eine SMD (Surface Mounted Device)-Ausführung vorgeschlagen (Fig. 6), bei der die Elemente der Untereinheiten als SMD-Elemente ausgebildet sind, die in der ringförmigen Nut untergebracht und mit dem Aussenring 8c bzw. Gatering 9 über geeignete Kontaktfedern 13 verbunden ist.

Auf diese Weise können die Verbindungen und Komponenten der Ansteuereinheit getrennt vom Einbau in den kathodenseitigen Steuerkopf mit herkömmlichen Mitteln der SMD-Technik hergestellt und durch einfaches Einstecken montiert werden.

Es versteht sich von selbst, dass im Rahmen der Erfindung viele andere Ausführungsformen denkbar sind. Insbesondere kann der Hochleistungsschalter anstelle der hier beschriebenen rotationssymmetrischen Form auch beliebige andere Formen (z.B. rechteckige) aufweisen.

Insgesamt kann mit der Erfindung der Leistungsbereich von Hochleistungsschaltern aufgrund der verbesserten Ansteuerung erheblich erweitert werden.

## Patentansprüche

1. Hochleistungsschalter, umfassend
(a) ein über ein Gate abschaltbares Halbleiterbauelement; und
(b) eine Ansteuereinheit (AS), welche den zum Abschalten notwendigen Gatestrom erzeugt; wobei
(c) die Ansteuereinheit (AS) in eine Mehrzahl von parallel arbeitenden Untereinheiten (AS1,...,ASn) aufgeteilt ist, welche jeweils einen Teil des zum Abschalten notwendigen Gatestroms erzeugen;
dadurch gekennzeichnet, dass
(d) das abschaltbare Halbleiterbauelement eine räumlich verteilt angeordnete Gateelektrode (14) aufweist; und
(e) die Untereinheiten (AS1,...,ASn) an verschiedenen Stellen der räumlich verteilten Gateelektrode (14) angeschlossen sind.

2. Hochleistungsschalter nach Anspruch 1, dadurch gekennzeichnet, dass das abschaltbare Halbleiterbauelement ein Abschaltthyristor (1) vom Typ eines GTO, FCTh oder SITh ist, und eine Anode (A), eine Kathode (K) und ein Gate (G) aufweist.

5

3. Hochleistungsschalter nach Anspruch 2, dadurch gekennzeichnet, dass

(a) jede der Untereinheiten (AS1, ..., ASn) einen Kondensator (C1, ..., Cn) und einen Halbleiterschalter enthält;

(b) in jeder Untereinheit (AS1, ..., ASn) der Kondensator (C1, ..., Cn) mit seiner einen Seite an die Kathode (K) des Abschaltthyristors (1), und mit seiner anderen Seite an eine gemeinsame Steuerspannung ($V_S$) und über die Schaltstrecke des Halbleiterschalters an die Gateelektrode (14) des Abschaltthyristors (1) angeschlossen ist; und

(c) die Steuerelektrode der Halbleiterschalter in einen gemeinsamen Steuereingang (5) zusammengeführt sind.

4. Hochleistungsschalter nach Anspruch 3, dadurch gekennzeichnet, dass die Kondensatoren (C1, .., Cn) in den Untereinheiten (AS1, .., ASn) als Multilayer-Keramikkondensatoren ausgebildet sind.

5. Hochleistungsschalter nach Anspruch 4, dadurch gekennzeichnet, dass

(a) der Abschaltthyristor (1) ein grossflächiges Halbleitersubstrat (6) umfasst;

(b) das Halbleitersubstrat (6) zwischen einer Anodenplatte (7) und einer Kathodenplatte (8) angeordnet ist;

(c) die Kathodenplatte (8) einen zylindrischen Zentralteil (8a), eine an den Zentralteil (8a) anschliessende, radial nach aussen verlaufende Erweiterung (8b), und einen an die Erweiterung anschliessenden Aussenring (8c) umfasst;

(d) der zylindrische Zentralteil (8a) der Kathodenplatte (8) von einem isoliert aufgebauten Gatering (9) umgeben ist, welcher konzentrisch zum Aussenring (8c) angeordnet ist, die Gateelektrode des Abschaltthyristors (1) kontaktiert, und mit dem grösseren Aussenring (8c) eine ringförmige Nut bildet; und

(e) in der ringförmigen Nut auf dem Kreisumfang verteilt die Untereinheiten (AS1, ..., ASn) mit ihren Elementen angeordnet und direkt an die beiden Ringe (8c, 9) angeschlossen sind.

6. Hochleistungsschalter nach Anspruch 5, dadurch gekennzeichnet, dass

(a) die Elemente der Untereinheiten als SMD (Surface Mounted Devices)-Elemente ausgeführt sind;

(b) die Elemente auf einer ringförmigen Montageplatte (12) angeordnet sind; und

(c) die Montageplatte (12) in der ringförmigen Nut untergebracht ist und mit den Ringen (8c, 9) über Kontaktfedern (13) in Verbindung steht.

7. Hochleistungsschalter nach einem der Ansprüche 3 bis 6, dadurch gekennzeichnet, dass die Halbleiterschalter als Ansteuertransistoren (T1, ..., Tn) in Form von MOSFETs ausgebildet sind.

8. Hochleistungsschalter nach einem der Ansprüche 3 bis 6, dadurch gekennzeichnet, dass die Halbleiterschalter als Ansteuerthyristoren in Form von FCThs ausgebildet sind.

## Claims

1. Heavy-duty circuit breaker comprising

(a) a semiconductor component which can be turned off via a gate; and

(b) a control unit (AS) which generates the gate current necessary for turn-off;

(c) the control unit (AS) being subdivided into a plurality of parallel-working sub-units (AS1, ..., ASn) each of which generates part of the gate current necessary for turn-off;

characterised in that

(d) the turn-off-type semiconductor component exhibits a gate electrode (14) which is arranged to be spatially distributed; and

(e) the sub-units (AS1, ..., ASn) are connected at various places of the spatially distributed gate electrode (14).

2. Heavy-duty circuit breaker according to Claim 1, characterised in that the turn-off-type semiconductor component is a turn-off thyristor (1) of the type of a GTO, FCTh or SITh, and exhibits an anode (A), a cathode (K) and a gate (G).

3. Heavy-duty circuit breaker according to Claim 2, characterised in that

(a) each of the sub-units (AS1, ..., ASn) contains a capacitor (C1, ..., Cn) and a semiconductor switch;

(b) in each sub-unit (AS1, ..., ASn) the capacitor (C1, ..., Cn) is connected with one side to the cathode (K) of the turn-off thyristor (1) and with its other side to a common control voltage (VS) and via the switching path of the semiconductor switch to the gate electrode (14) of the turn-off thyristor (1); and

(c) the control electrode of the semiconductor switches are [sic] combined in a common control input (5).

4. Heavy-duty circuit breaker according to Claim 3, characterised in that the capacitors (C1, ..., Cn) in the sub-units (AS1, ..., ASn) are constructed as multi-layer ceramic capacitors.

5. Heavy-duty circuit breaker according to Claim 4, characterised in that

(a) the turn-off thyristor (1) comprises a large-area semiconductor substrate (6);

(b) the semiconductor substrate (6) is arranged between an anode plate (7) and a cathode plate (8);

(c) the cathode plate (8) comprises a cylindrical central part (8a), an extension (8b) which adjoins the central part (8a) and extends radially outward, and an outer ring (8c) which adjoins the extension;

(d) the cylindrical central part (8a) of the cathode plate (8) is surrounded by a gate ring (9) of insulated configuration which is arranged concentrically with respect to the outer ring (8c), contacts the gate electrode of the turn-off thyristor (1) and forms an annular groove with the larger outer ring (8c); and

(e) the sub-units (AS1, ..., ASn) with their elements are arranged distributed over the circumference of the circle in the annular groove and are directly connected to the two rings (8c, 9).

6. Heavy-duty circuit breaker according to Claim 5, characterised in that

(a) the elements of the sub-units are constructed as SMD (Surface Mounted Devices) elements;

(b) the elements are arranged on an annular assembly plate (12); and

(c) the assembly plate (12) is accommodated in the annular groove and is connected to the rings (8c, 9) via contact springs (13).

7. Heavy-duty circuit breaker according to one of Claims 3 to 6, characterised in that the semiconductor switches are constructed as control transistors (T1, ..., Tn) in the form of MOSFETs.

8. Heavy-duty circuit breaker according to one of Claims 3 to 6, characterised in that the semiconductor switches are constructed as control thyristors in the form of FCThs.

## Revendications

1. Disjoncteur à haut pouvoir de coupure comportant :

(a) un composant semi-conducteur déclenchable par l'intermédiaire d'une gâchette, et

(b) une unité d'amorçage (AS) qui produit le courant de gâchette nécessaire pour le déclenchement; dans lequel :

(c) l'unité d'amorçage (AS) est divisée en un grand nombre de sous-unités (AS1, ..., ASn) fonctionnant en parallèle qui produisent chacune une partie du courant de gâchette nécessaire au déclenchement; caractérisé en ce que :

(d) le composant semi-conducteur déclenchable comporte une électrode de gâchette (14) répartie dans l'espace, et

(e) les sous-unités (AS1, ..., ASn) sont connectées à divers endroits de l'électrode de gâchette (14) répartie dans l'espace.

2. Disjoncteur à haut pouvoir de coupure suivant la revendication 1, caractérisé en ce que le composant semi-conducteur déclenchable comporte un thyristor déclenchable (1) du type d'un GTO, d'un FCTh ou d'un SITh ainsi qu'une anode (A), une cathode (R) et une gâchette (G).

3. Disjoncteur à haut pouvoir de coupure suivant la revendication 2, caractérisé en ce que :

(a) chacune des sous-unités (AS1, ..., ASn) contient un condensateur (C1, ..., Cn) et un interrupteur à semi-conducteur;

(b) dans chaque sous-unité (AS1, ..., ASn), le condensateur (C1, ..., Cn) est connecté par un côté à la cathode (K) du thyristor déclenchable (1) et par son autre côté à une tension de commande commune ($V_s$) et est connecté par le trajet de commutation de l'interrupteur à semi-conducteur à l'électrode de gâchette (14) du thyristor déclenchable (1), et

(c) les électrodes de commande des interrupteurs à semi-conducteurs sont rassemblées en une entrée de commande commune (5).

4. Disjoncteur à haut pouvoir de coupure suivant la revendication 3, caractérisé en ce que les condensateurs (C1, ... , Cn) des sous-unités (AS1, ..., ASn) ont la forme de condensateurs multicouches en céramique.

5. Disjoncteur à haut pouvoir de coupure suivant la revendication 4, caractérisé en ce que :

(a) le thyristor déclenchable (1) comporte un substrat semi-conducteur de grande étendue superficielle (6);

(b) le substrat semi-conducteur (6) est disposé entre une plaque d'anode (7) et une plaque de cathode (8);

(c) la plaque de cathode (8) comporte une partie centrale cylindrique (8a), un élargissement (8b) se raccordant à la partie centrale (8a) et s'étendant radialement vers l'extérieur et un anneau extérieur (8c) se raccordant à l'élargissement;

(d) la partie centrale cylindrique (8a) de la plaque de cathode (8) est entourée d'un anneau de gâchette (9) de structure isolée qui est disposé concentriquement à l'anneau extérieur (8c), est en contact avec l'électrode de gâchette du thyristor déclenchable (1) et forme avec l'anneau extérieur plus grand (8c) une gorge annulaire, et

(e) les éléments des sous-unités (AS1, ..., ASn) sont disposés répartis dans la gorge annulaire sur la périphérie circulaire de celle-ci, et sont connectés directement aux deux anneaux (8c, 9).

6. Disjoncteur à haut pouvoir de coupure suivant la revendication 5, caractérisé en ce que :

(a) les éléments des sous-unités ont la forme d'éléments SMD (Surface Mounted Devices);

(b) les éléments sont disposés sur une plaque de montage annulaire (12), et

(c) la plaque de montage (12) est logée dans la gorge annulaire et est connectée aux anneaux (8c, 9) par des ressorts de contact (13).

7. Disjoncteur à haut pouvoir de coupure suivant l'une quelconque des revendications 3 à 6, caractérisé en ce que les interrupteurs à semi-conducteurs ont la forme de transistors d'amorçage (T1, ..., Tn), en l'occurrence de MOSFET.

8. Disjoncteur à haut pouvoir de coupure suivant l'une quelconque des revendications 3 à 6, caractérisé en ce que les interrupteurs à semi-conducteurs ont la forme de thyristors d'amorçage, en l'occurrence de FCTh.

FIG.1

FIG.2

FIG.3A

FIG.3B

FIG.4

FIG.5

FIG.6